# EUROPÄISCHE PATENTSCHRIFT

(11) **EP 3 665 869 B1**
(45) Veröffentlichungstag und Bekanntmachung des Hinweises auf die Patenterteilung: **22.06.2022**
(21) Anmeldenummer: 18745549.8
(22) Anmeldetag: 19.07.2018
(51) Int. Cl.: H04L 12/40

(54) **SENDE-/EMPFANGSEINRICHTUNG FÜR EIN BUSSYSTEM UND VERFAHREN ZUR REDUZIERUNG EINER SCHWINGNEIGUNG BEIM ÜBERGANG ZWISCHEN UNTERSCHIEDLICHEN BITZUSTÄNDEN**
TRANSCEIVER FOR A BUS SYSTEM, AND METHOD FOR REDUCING AN OSCILLATION INCLINATION UPON TRANSITIONING BETWEEN DIFFERENT BIT STATES
DISPOSITIF D'ÉMISSION/RÉCEPTION POUR SYSTEME DE BUS ET PROCÉDÉ DE RÉDUCTION DE LA TENDANCE À OSCILLER ENTRE DIFFERENTS ÉTATS BINAIRES

(30) Priorität: 08.08.2017 DE 102017213832
(43) Veröffentlichungstag der Anmeldung: 17.06.2020
(73) Patentinhaber: Robert Bosch GmbH, 70442 Stuttgart (DE)
(72) Erfinder: PANNWITZ, Axel, 01445 Radebeul (DE); WALKER, Steffen, 72770 Reutlingen (DE); BRANDO, Cyrille, 72654 Neckartenzlingen (DE)
(86) Internationale Anmeldenummer: PCT/EP2018/069672
(87) Internationale Veröffentlichungsnummer: WO 2019/029974

(56) Entgegenhaltungen:
- US-A1- 2014 330 996
- US-A1- 2016 196 230

## Beschreibung

Die vorliegende Erfindung betrifft eine Sende-/Empfangseinrichtung für ein Bussystem und ein Verfahren zur Reduzierung einer Schwingneigung beim Übergang zwischen unterschiedlichen Bitzuständen, welche beispielsweise bei einer Teilnehmerstation für ein CAN-Bussystem zum Einsatz kommen können. Die Reduzierung der Schwingneigung wird mit Hilfe einer speziellen Verschaltung zu einem Busvorspannungspotenzial erzielt.

### Stand der Technik

Bei einer Nachrichten- oder Datenübertragung in einem Bussystem werden Informationen, die in Bytes bzw. Bits der Nachrichten oder Daten enthalten sind, durch unterschiedliche Bitzustände oder Spannungszustände dargestellt. Die unterschiedlichen Bitzustände haben beim Übertragen der Nachricht über einen Bus des Bussystems unterschiedliche Buszustände zur Folge. Je nach Bussystem existieren für Nachrichten- oder Datenübertragung verschiedene Übertragungsprotokolle.

Beispielsweise werden beim CAN-Bussystem Nachrichten mittels des CAN- und/oder CAN FD Protokolls übertragen, wie es im Standard ISO-11898-1:2015 als CAN Protokoll-Spezifikation mit CAN FD beschrieben ist. Das CAN-Bussystem ist heute für die Kommunikation zwischen Sensoren und Steuergeräten weit verbreitet. Oft wird das CAN-Bussystem in Fahrzeugen oder Automatisierungsanlagen, usw. für eine Kommunikation zwischen den einzelnen Busteilnehmern eingesetzt.

insbesondere bei der CAN/CAN-FD-Kommunikation müssen die Sende-/Empfangseinrichtungen, die auch Transceiver genannt werden, in der Lage sein, den Bus niederohmig treiben zu können, um einen dominanten Buszustand oder Bitzustand als einen der beiden verschiedenen Buszustände oder Bitzustände herzustellen. Im Rezessivzustand als dem anderen der beiden verschiedenen Buszustände dagegen sind die Sende-/Empfangseinrichtungen verhältnismäßig hochohmig.

Der Übergang von Dominant nach Rezessiv ist je nach Bustopologie, Länge der Stubs bzw. Stichleitungen, Position und Anzahl der Terminationswiderstände mit einer Schwingneigung behaftet. Dies ist sehr unvorteilhaft bei der Systemaustegung, weil infolgedessen die Bitzeit so lang sein muss, bis die Schwingung ausreichend bedämpft ist. Ist die Bitzeit nicht lang genug, kann die Sende-/Empfangseinrichtung im Rezessivzustand fälschlicherweise ein Dominant erkennen. Daher bedingt eine Einhaltung der maximal zulässigen Fehlerquote der Sende-/Empfangseinrichtung eine längere Bitzeit, was eine unerwünschte Reduzierung der Übertragungsrate oder Übertragungsgeschwindigkeit der Nachrichten im Bussystem zur Folge hat.

Die Offenlegungsschrift US 2016/0196230 A1 offenbart ein Verfahren und eine entsprechende Vorrichtung zum Betreiben eines digitalen Zweidrahtbusses, bei dem eine Bias-Spannung über eine ersten Schnittstelle an den Bus angelegt wird, eine Common-Mode-Spannung des Zweidrahtbusses an der ersten Schnittstelle ermittelt wird, und basierend auf der ermittelten Common-Mode-Spannung die Bias-Spannung angepasst wird.

Das Dokument US 2014/0330996 A1 offenbart eine Sendeschaltung für ein Bussystem, bei der mittels einer ersten Treiberstufe ein dominanter Buszustand eingestellt wird und mittels einer zweiten Treiberstufe ein rezessiver Buszustand eingestellt werden kann, wobei die Sendeschaltung eine Steuerschaltung umfasst, die dazu eingerichtet ist, dass die zweite Treiberschaltung nur in einem bestimmten Übertragungsmodus aktiviert wird.

### Offenbarung der Erfindung

Daher ist es Aufgabe der vorliegenden Erfindung, eine Sende-/Empfangseinrichtung für ein Bussystem und ein Verfahren zur Reduzierung einer Schwingneigung beim Übergang zwischen unterschiedlichen Bitzuständen bereitzustellen, welche die zuvor genannten Probleme lösen. Insbesondere sollen eine Sende-/Empfangseinrichtung für ein Bussystem und ein Verfahren zur Reduzierung einer Schwingneigung beim Übergang zwischen unterschiedlichen Bitzuständen oder Spannungszuständen, insbesondere einer Schwingneigung beim Übergang vom dominanten zum rezessiven Zustand, in einem Bussystem bereitgestellt werden.

Die Aufgabe wird durch eine Sende-/Empfangseinrichtung für ein Bussystem mit den Merkmalen von Anspruch 1 gelöst. Die Sende-/Empfangseinrichtung umfasst einen Empfangskomparator zum Empfang eines Signals, das von einem Bus des Bussystems übertragen wird, bei welchem Bussystem zumindest zeitweise ein exklusiver, kollisionsfreier Zugriff einer Teilnehmerstation auf den Bus des Bussystems gewährleistet ist, und einer Schwingungsreduktionseinheit, deren Eingang parallel zu dem Eingang des Empfangskomparators geschaltet ist, wobei die Schwingungsreduktionseinheit ausgestaltet ist, bei Erfassen eines Zustandswechsels des empfangenen Signals von einem dominanten Buszustand zu einem rezessiven Buszustand mindestens eine Busader des Busses mit einem Busvorspannungspotenzial zu verbinden.

Mit der beschriebenen Sende-/Empfangseinrichtung ist eine Reduzierung der Schwingdauer oder ein sogenanntes Ringing Suppression beim Übergang von Dominant nach Rezessiv möglich, woraus eine Erhöhung der Bitraten folgt, insbesondere im Datenbereich einer Nachricht. Als Folge davon steigt die Übertragungsrate oder Übertragungsgeschwindigkeit der Nachrichten im Bussystem.

Zudem erlaubt eine Reduzierung der Schwingdauer beim Übergang zwischen unterschiedlichen Bitzuständen oder Spannungszuständen, insbesondere beim CAN-Bussystem von Dominant nach Rezessiv, mehr Freiheit bei der Auslegung von Bustopologien und/oder von Abschlüssen und/oder von Stubs und/oder von der Anzahl der Knoten bzw. Teilnehmerstationen des Bussystems.

Noch dazu wird durch die beschriebene Ausgestaltung der Sende-/Empfangseinrichtung eine vorteilhafte Veränderung des Spektrums bei leitungsgebundener Emission erzielt. Die Abstrahlung von Emissionen kann nämlich im kritischen Frequenzbereich verringert werden, der beispielsweise zwischen ca. ein und ca. drei MHz liegt, was der Resonanzfrequenz aus Gleichtaktdrossel und parasitären Kapazitäten entspricht. Stattdessen tritt durch die beschriebene Sende-/Empfangseinrichtung die Abstrahlung von Emissionen in dem unkritischen Frequenzbereich auf, der bei dem genannten Beispiel bei Frequenzen größer als ca. 10MHz liegt, und bei dem die Drossel wirkt.

Die Sende-/Empfangseinrichtung ist für alle Kommunikationssysteme geeignet, bei welchen ein Buszustand aktiv getrieben wird, wie insbesondere bei einem CAN-Bussystem, einem CAN-HS-Bussystem, einem CAN-FD-Bussystem, usw. Bei einem CAN-HS-Bussystem (HS = Hochgeschwindigkeit = Highspeed) ist eine Datenübertragungsrate von bis zu 500 kBit pro Sekunde (500 kbps) möglich. Bei einem CAN FD-Bussystem ist eine Datenübertragungsrate von größer 1 MBit pro Sekunde (1Mbps) möglich.

Vorteilhafte weitere Ausgestaltungen der Sende-/Empfangseinrichtung sind in den abhängigen Ansprüchen beschrieben.

Möglicherweise ist das Busvorspannungspotenzial auf die Hälfte des Werts der Spannungsversorgung für den Bus eingestellt.

Erfindungsgemäss weist die Schwingungsreduktionseinheit einen Erfassungsblock und Transistoren auf, wobei der Erfassungsblock ausgestaltet ist, einen Zustandswechsel des empfangenen Signals von dem dominanten Buszustand zu dem rezessiven Buszustand zu erfassen, und wobei die Transistoren verschaltet sind, um bei Erfassen eines Zustandswechsels des empfangenen Signals von dem dominanten Buszustand zu dem rezessiven Buszustand die mindestens eine Busader des Busses mit einer Busvorspannungseinheit zu verbinden.

Erfindungsgemäss weist die Schwingungsreduktionseinheit einen Phasenlage-Erfassungsblock zum Erfassen der zeitlichen Lage der Signale auf den Busadern des Busses zueinander, und mindestens einen RS-Zeitsteuerungsblock auf, der jeweils zum Steuern des Signals auf einer Busader in Abhängigkeit von dem Erfassungsergebnis des Phasenlage-Erfassungsblocks ausgestaltet ist, um die Phasenlage des Signals auf der Busader einzustellen.

Gemäß einem Ausführungsbeispiel weist die Schwingungsreduktionseinheit einen Kommunikationsphasen-Erfassungsblock zum Erfassen von unterschiedlichen Phasen einer Kommunikation auf dem Bus auf, wobei mindestens ein RS-Zeitsteuerungsblock ausgestaltet ist, das Signal auf einer Busader abhängig von der erfassten Phase der Kommunikation auf dem Bus zu steuern. Hierbei kann der Kommunikationsphasen-Erfassungsblock ausgestaltet sein, mindestens ein Endebit zu erfassen, welches das Ende einer Nachricht anzeigt, um die unterschiedlichen Phasen einer Kommunikation auf dem Bus zu erfassen. Außerdem ist es möglich, dass der mindestens eine RS-Zeitsteuerungsblock ausgestaltet ist, das Signal auf einer Busader nach Abschluss einer Arbitrationsphase der Kommunikation zu steuern.

Gemäß noch einer Ausgestaltung ist es möglich, dass die Sende-/Empfangseinrichtung einen Sender zum Senden von Nachrichten auf den Bus aufweist und die Schwingungsreduktionseinheit derart ausgestaltet ist, dass die Schwingungsreduktionseinheit nur aktiviert ist, wenn der Sender eine Nachricht auf den Bus sendet.

Die zuvor beschriebene Sende-/Empfangseinrichtung kann Teil eines Bussystems sein, das einen Bus, und mindestens zwei Teilnehmerstationen aufweist, welche über den Bus derart miteinander verbunden sind, dass sie miteinander kommunizieren können. Hierbei weist mindestens eine der mindestens zwei Teilnehmerstationen eine zuvor beschriebene Sende-/Empfangseinrichtung auf.

Von den mindestens zwei Teilnehmerstationen kann mindestens eine Teilnehmerstation eine Kommunikationssteuereinrichtung aufweisen, welche ausgestaltet ist, ein Signal an die Sende-/Empfangseinrichtung zu senden, welches die Sende-/Empfangseinrichtung als Grundlage für die Signale für die Busadern verwendet, und das Signal mit einem von der Sende-/Empfangseinrichtung vom Bus empfangenen Signal zur Erzeugung eines Steuersignals zu vergleichen, und wobei die Kommunikationssteuereinrichtung ausgestaltet ist, das Steuersignal zur Steuerung der Schwingungsreduktionseinheit an die Sende-/Empfangseinrichtung auszugeben.

Die zuvor genannte Aufgabe wird zudem durch ein Verfahren zur Reduzierung einer Schwingneigung beim Übergang zwischen unterschiedlichen Bitzuständen mit den Merkmalen von Anspruch 9 gelöst.

Das Verfahren bietet dieselben Vorteile, wie sie zuvor in Bezug auf die Sende-/Empfangseinrichtung genannt sind.

Zeichnungen Nachfolgend ist die Erfindung unter Bezugnahme auf die beiliegende Zeichnung und anhand von Ausführungsbeispielen näher beschrieben. Es zeigen:
Fig. 1 ein vereinfachtes Blockschaltbild eines Bussystems gemäß einem ersten Ausführungsbeispiel;
Fig. 2 ein elektrisches Schaltbild einer Sende-/Empfangseinrichtung des Bussystems gemäß dem ersten Ausführungsbeispiel;
Fig. 3A einen zeitlichen Verlauf eines Sendesignals TxD bei der Sende-/Empfangseinrichtung gemäß dem ersten Ausführungsbeispiel sowie Fig. 3B einen zeitlichen Verlauf eines Sendesignals TxD bei einer herkömmlichen Sende-/Empfangseinrichtung;
Fig. 4A einen zeitlichen Verlauf der Bussignale CAN_H und CAN_L bei der Sende-/Empfangseinrichtung gemäß dem ersten Ausführungsbeispiel sowie Fig. 4B einen zeitlichen Verlauf der Bussignale CAN_H und CAN_L bei der herkömmlichen Sende-/Empfangseinrichtung;
Fig. 5A einen zeitlichen Verlauf einer Differenzspannung VDIFF der Bussignale CAN_H und CAN_L bei der Sende-/Empfangseinrichtung gemäß dem ersten Ausführungsbeispiel sowie Fig. 5B einen zeitlichen Verlauf der Differenzspannung VDIFF der Bussignale CAN_H und CAN_L bei der herkömmlichen Sende-/Empfangseinrichtung;
Fig. 6A einen zeitlichen Verlauf einer Empfängerausgabe bei der Sende-/Empfangseinrichtung gemäß dem ersten Ausführungsbeispiel sowie Fig. 6B einen zeitlichen Verlauf einer Empfängerausgabe bei der herkömmlichen Sende-/Empfangseinrichtung;
Fig. 7A einen zeitlichen Verlauf eines Empfangssignals RxD bei der Sende-/Empfangseinrichtung gemäß dem ersten Ausführungsbeispiel sowie Fig. 7B einen zeitlichen Verlauf eines Empfangssignals RxD bei einer herkömmlichen Sende-/Empfangseinrichtung;
Fig. 8 ein elektrisches Schaltbild einer Sende-/Empfangseinrichtung eines Bussystems gemäß einem zweiten Ausführungsbeispiel;
Fig. 9 ein Schaubild zur Veranschaulichung des Aufbaus einer Nachricht, die von einer Teilnehmerstation des Bussystems gemäß dem zweiten Ausführungsbeispiel gesendet wird; und
Fig. 10 ein elektrisches Schaltbild einer Sende-/Empfangseinrichtung eines Bussystems gemäß einem dritten Ausführungsbeispiel.

In den Figuren sind gleiche oder funktionsgleiche Elemente, sofern nichts anderes angegeben ist, mit denselben Bezugszeichen versehen.

### Beschreibung der Ausführungsbeispiele

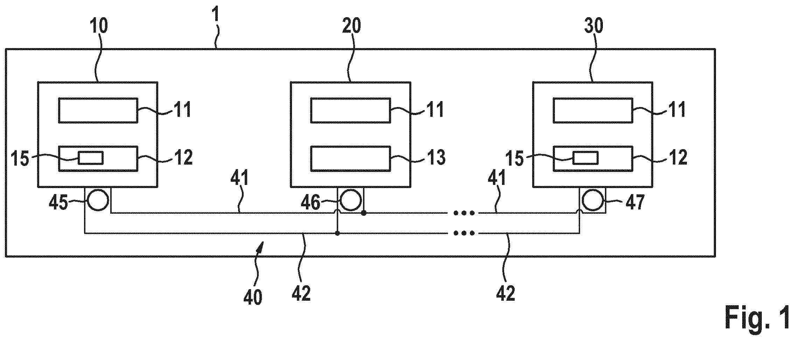

Fig. 1 zeigt ein Bussystem 1, das beispielsweise zumindest abschnittsweise ein CAN-Bussystem, ein CAN-FD-Bussystem, usw., sein kann. Das Bussystem 1 kann in einem Fahrzeug, insbesondere einem Kraftfahrzeug, einem Flugzeug, usw., oder im Krankenhaus usw. Verwendung finden.

In Fig. 1 hat das Bussystem 1 eine Vielzahl von Teilnehmerstationen 10, 20, 30, die jeweils an einen Bus 40 mit einer ersten Busader 41 und einer zweiten Busader 42 angeschlossen sind. Die Busadern 41, 42 können auch CAN_H und CAN_L genannt werden und dienen zur elektrischen Signalübertragung nach Einkopplung der dominanten Pegel bzw. Erzeugung von rezessiven Pegeln für ein Signal im Sendezustand. Über den Bus 40 können Nachrichten 45, 46, 47 in der Form von Signalen zwischen den einzelnen Teilnehmerstationen 10, 20, 30 übertragen werden. Die Teilnehmerstationen 10, 20, 30 können beispielsweise Steuergeräte oder Anzeigevorrichtungen eines Kraftfahrzeugs sein.

Wie in Fig. 1 gezeigt, haben die Teilnehmerstationen 10, 30 jeweils eine Kommunikationssteuereinrichtung 11 und eine Sende-/Empfangseinrichtung 12. Die Sende-/Empfangseinrichtungen 12 umfassen jeweils eine Schwingungsreduktionseinheit 15. Die Teilnehmerstation 20 hat dagegen eine Kommunikationssteuereinrichtung 11 und eine Sende-/Empfangseinrichtung 13. Die Sende-/Empfangseinrichtungen 12 der Teilnehmerstationen 10, 30 und die Sende-/Empfangseinrichtung 13 der Teilnehmerstation 20 sind jeweils direkt an den Bus 40 angeschlossen, auch wenn dies in Fig. 1 nicht dargestellt ist.

Die Kommunikationssteuereinrichtung 11 dient zur Steuerung einer Kommunikation der jeweiligen Teilnehmerstation 10, 20, 30 über den Bus 40 mit einer anderen Teilnehmerstation der an den Bus 40 angeschlossenen Teilnehmerstationen 10, 20, 30. Die Sende-/Empfangseinrichtung 12 dient zum Senden der Nachrichten 45, 47 in Form von Signalen und nutzt hierbei die Schwingungsreduktionseinheit 15, wie später noch ausführlicher beschrieben. Die Kommunikationssteuereinrichtung 11 kann insbesondere wie ein herkömmlicher CAN-FD-Controller und/oder CAN-Controller ausgeführt sein. Die Sende-/Empfangseinrichtung 13 kann insbesondere wie ein herkömmlicher CAN-Transceiver und/oder CAN-FD-Transceiver ausgeführt sein. Die Sende-/Empfangseinrichtung 13 kann insbesondere wie ein herkömmlicher CAN-Transceiver ausgeführt sein.

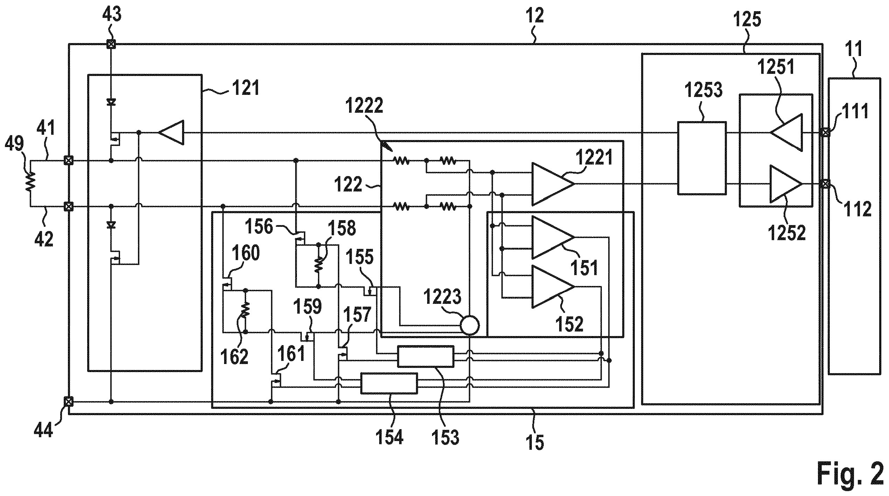

Fig. 2 zeigt den grundlegenden Aufbau der Sende-/Empfangseinrichtung 12 mit der Schwingungsreduktionseinheit 15. Die Sende-/Empfangseinrichtung 12 ist an den Bus 40, genauer gesagt dessen erste Busader 41 für CAN_H und dessen zweite Busader 42 für CAN_L angeschlossen. Die Spannungsversorgung, insbesondere CAN-Supply, für die erste und zweite Busader 41, 42 erfolgt über einen Anschluss 43. Der Anschluss an Masse bzw. CAN_GND ist über einen Anschluss 44 realisiert. Die erste und zweite Busader 41, 42 sind mit einem Abschlusswiderstand 49 terminiert.

Die erste und zweite Busader 41, 42 sind in der Sende-/Empfangseinrichtung 12 mit einem Sender 121, der auch als Transmitter bezeichnet wird, und mit einem Empfänger 122 verbunden, der auch als Receiver bezeichnet wird. Sowohl mit dem Sender 121 als auch dem Empfänger 122 ist eine Anschalteinheit 125 zum Treiben von Signalen über die Anschlüsse 111, 112 an die Kommunikationssteuereinrichtung 11 verbunden.

In Fig. 2 ist der Sender 121 aufgebaut wie ein herkömmlicher Sender einer Sende-/Empfangseinrichtung 12 und ist daher hier nicht weiter erläutert.

Zum Treiben der Signale der Anschlüsse 111, 112 hat die Anschalteinheit 125 einen Sendesignaltreiber 1251 für ein Sendesignal TxD, das auch als TxD-Signal bezeichnet wird und an dem Anschluss 111 von der Kommunikationssteuereinrichtung 11 empfangen wird. Zudem hat die Anschalteinheit 125 einen Empfangssignaltreiber 1252 für ein Empfangssignal RxD, das auch als RxD-Signal bezeichnet wird, von den Busadern 41, 42 mittels des Empfängers 122 empfangen wurde und über den Anschluss 112 an die Kommunikationssteuereinrichtung 11 weitergegeben wird. Die Treiber 1251, 1252 sind über ein Digitalteil 1253 mit dem Sender 121 und dem Empfänger 122 verbunden. Das Digitalteil 1253 kann eine Überwachung der Signale TxD, RxD durchführen.

Der Empfänger 122 hat einen Empfangskomparator 1221, dessen Eingang in einem resistiven, insbesondere symmetrischen Spannungsteiler 1222, genauer gesagt dessen Mittelabgriff, verschaltet ist, und eine Busvorspannungseinheit 1223. Die Busvorspannungseinheit 1223 speist den resistiven Spannungsteiler 1222 an seinem einen Ende mit einer vorbestimmten Busvorspannung oder einem vorbestimmten Busvorspannungspotenzial. Der resistive Spannungsteiler 1222 ist an seinem anderen Ende an die erste und zweite Busader 41, 42 angeschlossen. Sowohl der Eingang des Empfangskomparators 1221 als auch die Busvorspannungseinheit 1223 sind mit der Schwingungsreduktionseinheit 15 verschaltet, wie nachfolgend ausgeführt.

Die Schwingungsreduktionseinheit 15 umfasst einen Zustandswechsel-Erfassungsblock 151 und einen Phasenlage-Erfassungsblock 152, deren Eingänge jeweils parallel zu dem Eingang des Empfangskomparators 1221 geschaltet sind. Die Ausgänge der Blöcke 151, 152 sind zum einen an einen RS-Zeitsteuerungsblock 153 für das Signal auf der ersten Busader 41 bzw. CAN_H angeschlossen bzw. mit dem RS-Zeitsteuerungsblock 153 verbunden. Zum anderen sind die Ausgänge der Blöcke 151, 152 an einen RS-Zeitsteuerungsblock 154 für das Signal auf der zweiten Busader 42 bzw. CAN_L angeschlossen bzw. mit dem RS-Zeitsteuerungsblock 154 verbunden. Darüber hinaus umfasst die Schwingungsreduktionseinheit 15 drei Transistoren 155, 156, 157, die jeweils mit einem Widerstand 158 verschaltet sind, und drei Transistoren 159, 160, 161, die jeweils mit einem Widerstand 162 verschaltet sind. Die Transistoren 155, 156, 157, 159, 160, 161 sind vorzugsweise Feldeffekttransistoren. Die Transistoren 156 und 160sind beispielsweise PMOS-Transistoren, die Transistoren 155, 157, 159, 161 sind beispielsweise NMOS-Transistoren.

Der Transistor 156 ist an seinem Drain-Anschluss an die erste Busader 41, also CAN_H, angeschlossen. Der Widerstand 158 ist zwischen den Gate-Anschluss des Transistors 156 und den Source-Anschluss des Transistors 156 geschaltet. Zudem ist der Source-Anschluss des Transistors 156 mit dem Drain-Anschluss des Transistors 155 verbunden. Der Gate-Anschluss des Transistors 156 ist mit dem Drain-Anschluss des Transistors 157 verbunden. Der Gate-Anschluss des Transistors 155 ist mit dem RS-Zeitsteuerungsblock 153 verbunden, genauer gesagt einem Ausgang des RS-Zeitsteuerungsblocks 153. Der Source-Anschluss des Transistors 155 ist mit der Busvorspannungseinheit 1223 verbunden. An dem Gate-Anschluss des Transistors 157 ist der RS-Zeitsteuerungsblock 153 angeschlossen, genauer gesagt ein weiterer Ausgang des RS-Zeitsteuerungsblocks 153. Der Source-Anschluss des Transistors 157 ist über den Anschluss 44 an Masse bzw. CAN_GND angeschlossen.

Der Transistor 160 ist an seinem Drain-Anschluss an die zweite Busader 42, also CAN_L, angeschlossen. Der Widerstand 162 ist zwischen den Gate-Anschluss des Transistors 160 und den Source-Anschluss des Transistors 160 geschaltet. Zudem ist der Source-Anschluss des Transistors 160 mit dem Drain-Anschluss des Transistors 159 verbunden. Der Gate-Anschluss des Transistors 160 ist mit dem Drain-Anschluss des Transistors 161 verbunden. Der Gate-Anschluss des Transistors 159 ist mit dem RS-Zeitsteuerungsblock 154 verbunden, genauer gesagt einem Ausgang des RS-Zeitsteuerungsblocks 154. Der Source-Anschluss des Transistors 159 ist mit der Busvorspannungseinheit 1223 verbunden. An dem Gate-Anschluss des Transistors 161 ist der RS-Zeitsteuerungsblock 154 angeschlossen, genauer gesagt ein weiterer Ausgang des RS-Zeitsteuerungsblocks 154. Der Source-Anschluss des Transistors 161 ist über den Anschluss 44 an Masse bzw. CAN_GND angeschlossen.

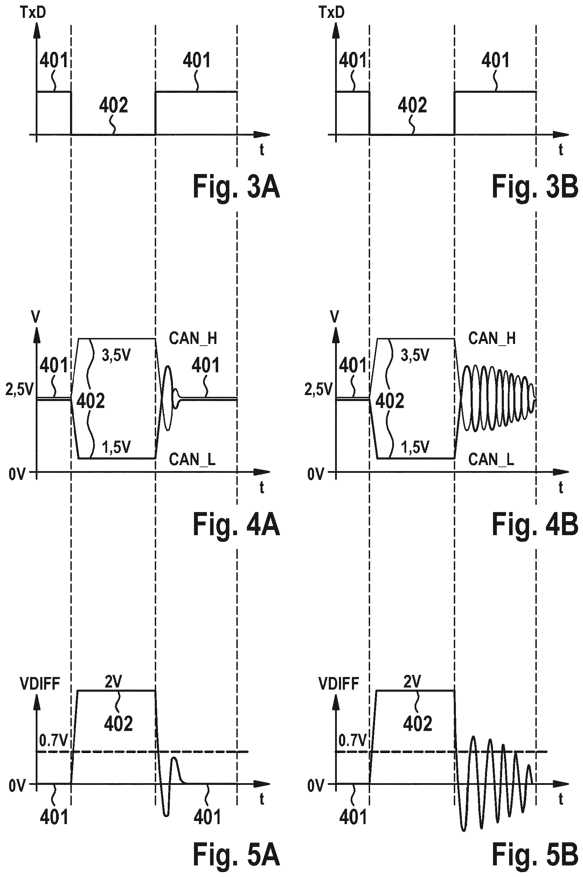

Der Betrieb der Sende-/Empfangseinrichtung 12 gemäß Fig. 2 ist nachfolgend auch anhand der Signalverläufe von Fig. 3A bis Fig. 7B näher erläutert.

Fig. 3A bis Fig. 7A zeigen jeweils einen zeitlichen Verlauf von Signalen bei der Sende-/Empfangseinrichtung 12 gemäß dem vorliegenden Ausführungsbeispiel. Hierbei stellen sich in Folge eines in Fig. 3A gezeigten Sendesignals TxD die Signale gemäß Fig. 4A bis Fig. 7A ein.

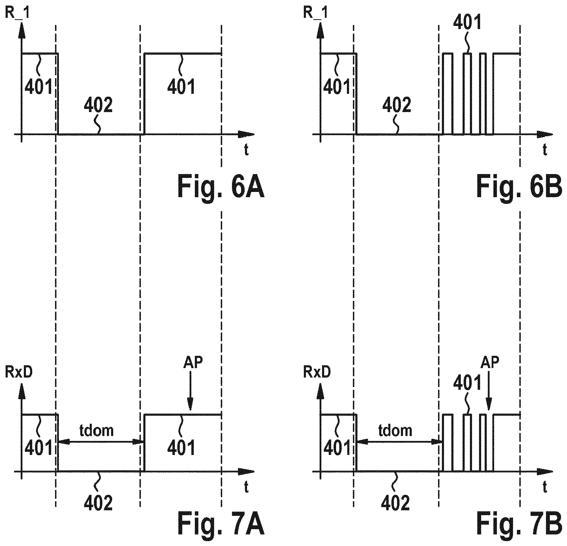

Bei dem Sendesignal TxD von Fig. 3A findet im Laufe der Zeit t bei drei aufeinanderfolgenden Bits ein Zustandswechsel von einem ersten Buszustand 401 zu einem zweiten Buszustand 402 und dann wieder zurück zu dem ersten Buszustand 401 statt. Der erste Buszustand 401 kann auch als Rezessivzustand oder hoher Pegel bezeichnet werden. Der zweite Buszustand 402 kann auch als Dominantzustand oder niedriger Pegel bezeichnet werden. In Folge des Sendesignals TxD von Fig. 3A stellt sich die Spannung V für die Signale CAN_H und CAN_L gemäß Fig. 4A ein, die Differenzspannung VDIFF VDIFF = CAN_H - CAN_L gemäß Fig. 5A ein, ein Ausgangssignal R_1 des Empfängers 122 gemäß Fig. 6A ein, und ein Empfangssignal RxD gemäß Fig. 7A ein. Die Spannung V für die Signale CAN_H und CAN_L gemäß Fig. 4A entspricht im ersten Buszustand 401 oder rezessiven Zustand der Hälfte des Busvorspannungspotenzials der Busvorspannungseinheit 1223.

Im Vergleich dazu sind in den Fig. 3B bis Fig. 7B jeweils die zeitlichen Verläufe von Signalen bei einer Sende-/Empfangseinrichtung gemäß einer herkömmlichen Sende-/Empfangseinrichtung veranschaulicht, wie beispielsweise der Sende-/Empfangseinrichtung 13 der Teilnehmerstation 20.

Aus dem Vergleich der Signale von Fig. 4A und Fig. 4B ergibt sich sehr deutlich, dass die Sende-/Empfangseinrichtung 12 gemäß dem vorliegenden Ausführungsbeispiel bei demselben Sendesignal TxD ein deutlich schnelleres Einschwingen der Signale CAN-H und CAN_L nach dem Zustandswechsel von dem Zustand 401 auf den Zustand 402 bzw. von Dominant nach Rezessiv bewirkt. Ist die Schwellwertspannung des Empfängers 122 auf den üblichen Wert von 0,7 V eingestellt, wie in Fig. 5A und Fig. 5B veranschaulicht, erkennt der Empfänger 122 auch bei einem Zustandswechsel von dem Zustand 401 auf den Zustand 402 bzw. von Dominant nach Rezessiv keine angeblichen Zustandswechsel mehr von dem Zustand 402 auf den Zustand 401 bzw. von Rezessiv nach Dominant, wie auch in Fig. 6A dargestellt. Somit kann eine Abtastung des Empfangssignals RxD bei dem derzeit üblichen Abtastpunkt AP sicher zu dem gewünschten Ergebnis führen, wie in Fig. 7A dargestellt. Dies gilt, auch wenn sich die Länge der Bitzeit tdom des Zustands 401 bzw. eines dominanten Bits gegenüber einer herkömmlichen Sende-/Empfangseinrichtung oder der Sende-/Empfangseinrichtung 13 der Teilnehmerstation 20 etwas verlängert, wie aus dem Vergleich von Fig. 7A und Fig. 7B ersichtlich.

Somit hat die Sende-/Empfangseinrichtung 12 gemäß dem vorliegenden Ausführungsbeispiel eine geringere Schwingneigung als eine herkömmliche Sende-/Empfangseinrichtung bzw. die Sende-/Empfangseinrichtung 13.

Im Betrieb der Sende-/Empfangseinrichtung 12 von Fig. 2 wird ein Wechsel des Buszustands 401 nach 402 bzw. von Dominant nach Rezessiv durch den Zustandswechsel-Erfassungsblock 151 erkannt, wenn bei dem TxD-Signal ein Rezessiv-Buszustand bzw. der Buszustand 401 mindestens für die Zeit eines Bits beginnt, wie in Fig. 3A veranschaulicht. Als Folge davon steuert der RS-Zeitsteuerungsblock 153 von Fig. 2 die beiden Schalttransistoren 155, 156 an, welche die erste Busader 41 mit der Busvorspannungseinheit 1223 und dadurch mit dem Bus-Biasing-Potenzial bzw. Busvorspannungspotenzial verbinden. Die Busvorspannungseinheit 1223 hat die Spannung für das Signal auf der Busader 41 auf die Hälfte des Werts der Spannungsversorgung an dem Anschluss 43 einzustellen. Insbesondere beträgt der Wert der Spannung bei CAN oder CAN FD oder CAN HS für den Rezessivzustand 2,5 V, wie in Fig. 4A angegeben.

Ebenso steuert als Folge des erkannten Zustandswechsels der RS-Zeitsteuerungsblock 154 von Fig. 2 die beiden Schalttransistoren 159, 160 an, welche die zweite Busader 42 mit der Busvorspannungseinheit 1223 und dadurch mit dem Bus-Biasing-Potenzial bzw. Busvorspannungspotenzial verbinden. Die Busvorspannungseinheit 1223 hat die Spannung für das Signal auf der Busader 42 auf die Hälfte des Werts der Spannungsversorgung an dem Anschluss 43 einzustellen, wie zuvor in Bezug auf den RS-Zeitsteuerungsblock 153 beschrieben.

Durch die beschriebene Ansteuerung der RS-Zeitsteuerungsblöcke 153, 154 wird eine im Schwingkreis vorhandene Energie über die Verbindung zur Busvorspannungseinheit 1223 abgebaut. Die RS-Zeitsteuerungsblöcke 153, 154 sind derart ausgestaltet, dass die Zeit der Ansteuerung der Schalttransistoren 155, 156 bzw. der Schalttransistoren 159, 160 in Bruchteilen der Bitzeit, vorzugsweise stufenlos, einstellbar ist. Die Einstellung kann entweder aufgrund einer Erfassung des Phasenlage-Erfassungsblocks 152 vorgenommen werden oder fest oder, insbesondere von einem Benutzer, konfigurierbar vorgegeben sein.

Der Phasenlage-Erfassungsblock 152 von Fig. 2 erfasst und bewertet die zeitliche Lage der Signale auf den beiden Busadern 41, 42 zueinander. Je nach Ergebnis steuert der Phasenlage-Erfassungsblock 152 die Schalttransistoren 155, 156 bzw. die Schalttransistoren 159, 160 über die RS-Zeitsteuerungsblöcke 153, 154 an. Gegebenenfalls kann die Bewertung der zeitlichen Lage der Signale auf den beiden Busadern 41, 42 zueinander auch zumindest teilweise von den RS-Zeitsteuerungsblöcken 153, 154 vorgenommen werden.

Somit kann ganz allgemein mit den RS-Zeitsteuerungsblöcken 153, 154 die Ansteuerung separat bzw. unabhängig voneinander für die Busadern 41, 42, insbesondere der Signale CAN_H und CAN_L, durchgeführt werden. In anderen Worten kann mit den RS-Zeitsteuerungsblöcken 153, 154 die Ansteuerung zeitlich getrennt für die Busadern 41, 42, insbesondere der Signale CAN_H, CAN_L, durchgeführt werden. Dadurch kann sich die Phasenlage der Signale auf den beiden Busadern 41, 42 ändern. Wird auch noch das Erfassungsergebnis des Phasenlage-Erfassungsblocks 152 mit herangezogen, kann die Phasenlage der Signale auf den beiden Busadern 41, 42 ganz gezielt verändert werden. Infolgedessen wird die Dämpfung der Schwingung nach dem Zustandswechsel noch weiter beschleunigt.

Wird eine gezielte Veränderung der Phasenlage der Signale auf den beiden Busadern 41, 42 nicht benötigt, kann der Phasenlage-Erfassungsblock 152 weggelassen werden.

Somit wird mit der Sende-/Empfangseinrichtung 12 ein Verfahren zur Reduzierung einer Schwingneigung beim Übergang zwischen unterschiedlichen Bitzuständen durchgeführt.

Bei dem beschriebenen Ausführungsbeispiel haben nur die Teilnehmerstationen 10, 30 die Funktionalität der Sende-/Empfangseinrichtung 12. Die Teilnehmerstationen 10, 30 sind vorzugsweise Teilnehmerstationen oder Knoten mit hoher Schwingneigung. Die hohe Schwingneigung der Teilnehmerstationen 10, 30 kann sich insbesondere durch deren Position im Bussystem 1, die Position der Terminationswiderstände 49, die Stub-Länge bzw. Stichleitungslänge zu den Teilnehmerstationen 10, 30, usw. ergeben.

Gemäß einer Modifikation des ersten Ausführungsbeispiels ist es gemäß einem vereinfachten Ansatz auch möglich, nur eines der beiden Schalterpaare aus den Transistoren 155 (NMOS), 156 (PMOS) bzw. 159 (NMOS), 160 (PMOS) für die Signale CAN_H oder CAN_L zu bedienen, um die Schwingungszeit nach dem Zustandswechsel von Dominant nach Rezessiv zu verkürzen. Dies bringt ebenfalls eine Verbesserung gegenüber einer herkömmlichen Sende-/Empfangseinrichtung oder der Sende-/Empfangseinrichtung 13 der Teilnehmerstation 20. In diesem Fall kann bei der Schaltung von Fig. 2 nur das Schalterpaar für die Signale CAN_H oder CAN_L vorhanden sein, das bedient werden soll.

Gemäß einer weiteren Modifikation des ersten Ausführungsbeispiels ist die zuvor beschriebene Funktionalität der Sende-/Empfangseinrichtung 12 nur aktiv, wenn die Sende-/Empfangseinrichtung 12 selbst sendet bzw. als Sender agiert. In diesem Fall wäre die Auswertung des Sendesignals TxD von Vorteil, so dass das Sendesignal TxD vom Anschluss 111 zumindest einem Block der RS-Zeitsteuerungsblöcke 153, 154 zugeführt wird.

Gemäß noch einer weiteren Modifikation des ersten Ausführungsbeispiels hat auch die Teilnehmerstation 20 anstelle einer Sende-/Empfangseinrichtung 13 eine Sende-/Empfangseinrichtung 12. In diesem Fall ist die zuvor beschriebene Funktionalität der Sende-/Empfangseinrichtung 12 für alle Teilnehmerstationen 10, 20, 30 des Bussystems aktiv, insbesondere je nach Bedarf.

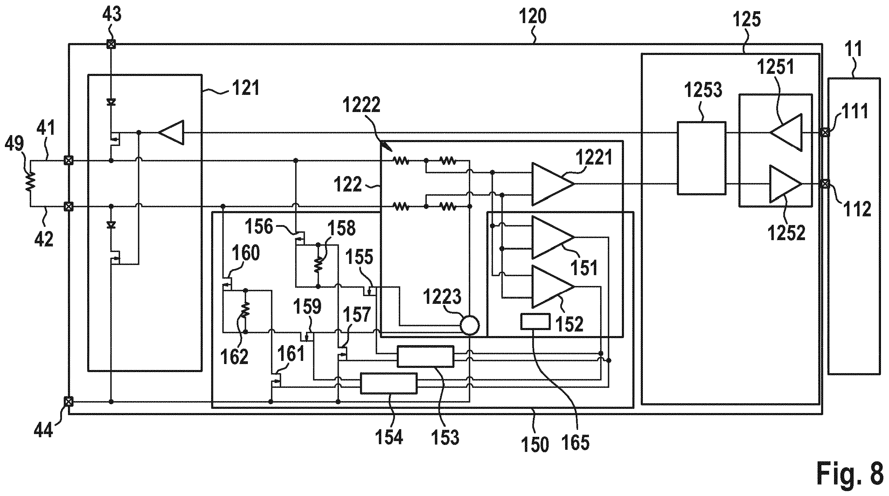

Fig. 8 zeigt den grundlegenden Aufbau einer Sende-/Empfangseinrichtung 120, die eine Schwingungsreduktionseinheit 150 aufweist. Das Bussystem 1 und die Sende-/Empfangseinrichtung 120 sind bis auf die nachfolgend beschriebenen Unterschiede auf die gleiche Weise aufgebaut, wie zuvor gemäß dem vorangehenden Ausführungsbeispiel oder seinen Modifikationen für das Bussystem 1 und die Sende-/Empfangseinrichtung 12 beschrieben.

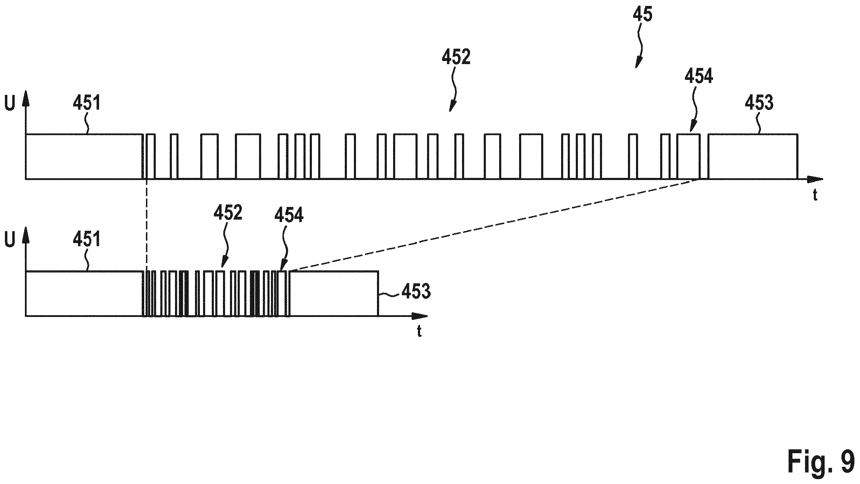

Die Schwingungsreduktionseinheit 150 hat zusätzlich einen Kommunikationsphasen-Erfassungsblock 153, welcher die unterschiedlichen Phasen einer Kommunikation auf dem Bus 40 erfassen und erkennen oder unterscheiden kann, die in Fig. 9 gezeigt sind.

Fig. 9 zeigt in ihrem oberen Teil anhand der Nachricht 45 einen CAN-Rahmen, wie er von der Sende-/Empfangseinrichtung 12 oder der Sende-/Empfangseinrichtung 13 gesendet wird, und in ihrem unteren Teil einen CAN-FD-Rahmen, wie er von der Sende-/Empfangseinrichtung 12 gesendet werden kann. Der CAN-Rahmen und der CAN-FD-Rahmen sind für die CAN-Kommunikation auf dem Bus 40 grundlegend in zwei unterschiedliche Kommunikationsphasen unterteilt, nämlich die Arbitrationsphasen 451, 453 und einen Datenbereich 452, der bei CAN-HS auch Datenfeld bzw. bei CAN-FD auch Datenphase genannt wird. Der Datenbereich 452 ist an seinem Ende mit mindestens einem Endebit 454 abgeschlossen, das auch EOF-Bit genannt wird, wobei EOF für End of Frame bzw. Ende der Nachricht steht. Bei CAN oder CAN FD ist das EOF eine Bitabfolge aus 11 rezessiven Bits, also Bits mit dem zweiten Buszustand 402.

Bei CAN-FD wird im Vergleich zum klassischen CAN am Ende der Arbitrationsphase 451 die Bitrate für die folgende Datenphase auf z. B. 2, 4, 8Mbps erhöht. Damit gilt, dass bei CAN-FD die Bitrate in den Arbitrationsphasen 451, 453 kleiner als die Bitrate im Datenbereich 452 ist. Bei CAN-FD ist der Datenbereich 452 gegenüber dem Datenbereich 452 des CAN-Rahmens deutlich verkürzt.

Die Arbitrationsphasen 451, 453 sind ein wichtiger Bestandteil eines CAN-Rahmens und eines CAN-FD-Rahmens bzw. der Nachrichten 45, 46, 47, die in Fig. 1 gezeigt sind. Dabei wird entschieden, welcher Knoten bzw. welche Teilnehmerstation 10, 20, 30 des Bussystems 1 die wichtigste Nachricht 45, 46, 47 trägt. Die Teilnehmerstation 10, 20, 30 mit der wichtigsten Nachricht 45, 46, 47 gewinnt die Arbitration und darf daher die Nachricht nach Abschluss der Arbitrationsphase senden. Alle anderen Teilnehmerstationen sind dann beim Übertragen dieser wichtigsten Nachricht Zuhörer. Hierbei treiben die Sende-/Empfangseinrichtungen 12, 13 den Bus 40 niederohmig, um einen dominanten Buszustand 402 (Fig. 3A bis Fig. 7A) oder Bitzustand als einen der beiden verschiedenen Buszustände 401, 402 oder Bitzustände herzustellen. Im Rezessivzustand als dem anderen der beiden verschiedenen Buszustände 401, 402 dagegen sind die Sende-/Empfangseinrichtungen 12, 13 verhältnismäßig hochohmig.

Der Kommunikationsphasen-Erfassungsblock 165 kann die Arbitrationsphasen 451, 453, den Datenbereich 452 sowie das Ende des Datenbereichs 453, also das mindestens eine Endebit (EOF) 454 erkennen. Dadurch kann die Funktionalität der Schwingungsreduktionseinheit 150 je nach Wunsch entweder für alle Kommunikationsphasen 451 bis 453 oder Phasen/Bereiche einer Nachricht 45 gelten oder nur bei abgeschlossener Arbitration, also für den Datenbereich 452. Letzteres ist sinnvoll, wenn ansonsten zu viele Teilnehmerstationen 10, 20, 30 gleichzeitig beim Arbitrieren die Funktion der Sende-/Empfangseinrichtung 120 aktivieren können und damit den effektiven Buswiderstand zu stark reduzieren.

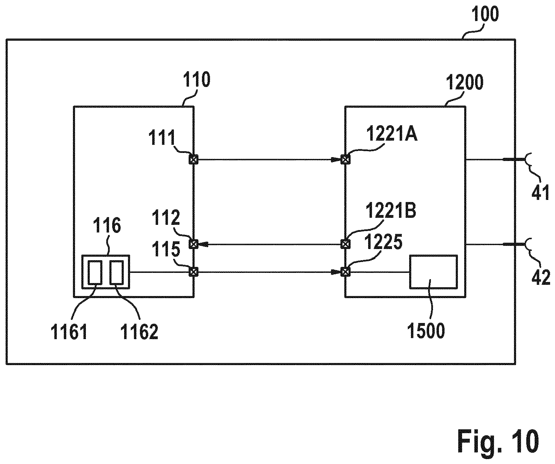

Fig. 10 zeigt den grundlegenden Aufbau einer Teilnehmerstation 100 mit einer Kommunikationssteuereinrichtung 110 und einer Sende-/Empfangseinrichtung 1200 gemäß einem dritten Ausführungsbeispiel. Das Bussystem 1 und die Teilnehmerstation 100 sind bis auf die nachfolgend beschriebenen Unterschiede auf die gleiche Weise aufgebaut, wie zuvor gemäß dem ersten Ausführungsbeispiel oder seinen Modifikationen für das Bussystem 1 und die Teilnehmerstation 10 beschrieben.

Die Kommunikationssteuereinrichtung 110 ist bis auf die nachfolgend beschriebenen Unterschiede aufgebaut wie die Kommunikationssteuereinrichtung 11 des ersten Ausführungsbeispiels. Die Sende-/Empfangseinrichtung 1200 ist bis auf die nachfolgend beschriebenen Unterschiede aufgebaut wie die Sende-/Empfangseinrichtung 12 des ersten Ausführungsbeispiels.

Die Kommunikationssteuereinrichtung 110 hat neben den Anschlüssen 111, 112 für die Signale TxD, RxD einen zusätzlichen Anschluss 115 für ein Steuersignal RS_Control_Out.

Die Sende-/Empfangseinrichtung 1200 hat einen Anschluss 1221A zum Empfang des Sendesignals TxD von dem Anschluss 111 der Kommunikationssteuereinrichtung 110, wie bereits zuvor in Bezug auf das erste Ausführungsbeispiel allgemeiner beschrieben. Außerdem hat die Sende-/Empfangseinrichtung 1200 einen Anschluss 1221B zum Senden des Empfangssignals RxD an den Anschluss 112 der Kommunikationssteuereinrichtung 110, wie bereits zuvor in Bezug auf das erste Ausführungsbeispiel allgemeiner beschrieben. Zusätzlich dazu weist die Sende-/Empfangseinrichtung 1200 einen Anschluss 1225 auf, an welchem das Steuersignal RS_Control_Out als Steuersignal RS_Control_In empfangen wird.

Zur Erzeugung des Steuersignals RS_Control_Out für den Anschluss 115 hat die Kommunikationssteuereinrichtung 110 einen Steuerblock 116. Der Steuerblock 116 überwacht den Busverkehr auf den Busadern 41, 42, indem der Steuerblock 116 das als erste Informationen 1161 gespeicherte Sendesignal TxD und das am Anschluss 112 empfangene, und bei Bedarf zwischengespeicherte, Empfangssignal RxD miteinander vergleicht. Treten im rezessiven Buszustand, also dem ersten Buszustand 401, Abweichungen zwischen den beiden Signalen TxD, RxD auf, wie beispielsweise Zustandswechsel im Empfangssignal RxD, die nicht in dem Sendesignal TxD enthalten waren, so können daraus Rückschlüsse über das Netzwerk bzw. den Bus 40 und die Signalintegrität gezogen werden.

Des Weiteren liegen in dem Steuerblock 116 der Kommunikationssteuereinrichtung 110 zweite Informationen 1162 vor, wie Bitrate, Ausbreitungsverzögerung (Propagation-Delay) für beide Schaltvorgänge, also einem Zustandswechsel von dem ersten Buszustand 401 zu dem zweiten Buszustand 402. Die Informationen 1162 können alternativ in einem nicht dargestellten weiteren Block, insbesondere Speicher, vorgehalten werden.

Dabei kann der RxD-Ausgang am Anschluss 1221B anstelle eines Digitalsignals das Ausgangssignal eines Analog-Digital-Wandlers sein, welcher die Differenzspannung des Empfangssignals RxD darstellt.

Unter Berücksichtigung dieser Informationen 1161, 1162 erzeugt der Steuerblock 116 das Steuersignal RS_Control_Out, welches von dem Anschluss 115 ausgegeben wird, an dem Anschluss 1225 der Sende-/Empfangseinrichtung 1200 empfangen wird und an die Schwingungsreduktionseinheit 1500 weitergegeben wird. Dementsprechend können bei der Schwingungsreduktionseinheit 1500 die Blöcke 151, 152, 153 der Schwingungsreduktionseinheiten 15, 150 der vorangehenden Ausführungsbeispiele entfallen.

Auf diese Weise wird die Steuerung der Reduktion der Schwingneigung (Ringing Suppression) hier nicht von der Sende-/Empfangseinrichtung 1200 gesteuert, sondern von der Kommunikationssteuereinrichtung 110. Hierbei kann die Kommunikationssteuereinrichtung 110, genauer gesagt ihr Steuerblock 116, die Schwingungsreduktionseinheit 1500 an die speziellen Eigenschaften der Teilnehmerstation 100 und des Netzwerks bzw. des Busses 40 anpassen. In anderen Worten, die Kommunikationssteuereinrichtung 110, genauer gesagt ihr Steuerblock 116, kann die Schwingungsreduktionseinheit 1500 Knoten- und Netzwerk-Sensitiv einstellen. Der Steuerblock 116 bietet damit eine Lernfunktion für die Teilnehmerstation 100.

Damit kann ebenso eine deutliche Reduktion der Schwingneigung bei dem Zustandswechsel vom zweiten Buszustand 402 zum ersten Buszustand 401 realisiert werden. Zudem kann dadurch ein deutlicher Gewinn für das Bussystem 1 als Gesamtsystem erreicht werden.

Alle zuvor beschriebenen Ausgestaltungen der Schwingungsreduktionseinheiten 15, 150,1500 der Sende-/Empfangseinrichtungen 12, 120, 1200 der Teilnehmerstationen 10, 20, 30, 100, des Bussystems 1 und des darin ausgeführten Verfahrens gemäß den Ausführungsbeispielen und deren Modifikationen können einzeln oder in allen möglichen Kombinationen Verwendung finden. Zusätzlich sind insbesondere folgende Modifikationen denkbar.

Das zuvor beschriebene Bussystem 1 gemäß den Ausführungsbeispielen und/oder deren Modifikationen ist anhand eines auf dem CAN-Protokoll basierenden Bussystems beschrieben. Das Bussystem 1 gemäß den Ausführungsbeispielen und/oder deren Modifikationen kann jedoch auch eine andere Art von Kommunikationsnetz sein. Es ist vorteilhaft, jedoch nicht zwangsläufige Voraussetzung, dass bei dem Bussystem 1 zumindest für bestimmte Zeitspannen ein exklusiver, kollisionsfreier Zugriff einer Teilnehmerstation 10, 20, 30, 100 auf die Busleitung 40 oder einen gemeinsamen Kanal der Busleitung 40 gewährleistet ist.

Das Bussystem 1 gemäß den Ausführungsbeispielen und/oder deren Modifikationen ist insbesondere ein CAN-Netzwerk oder ein CAN-HS-Netzwerk oder ein CAN FD-Netzwerk oder ein FlexRay-Netzwerk. Das Bussystem 1 kann jedoch auch ein anderes serielles Kommunikationssetzwerk sein.

Insbesondere kann die Schwingungsreduktionseinheit 15, 150 bei LVDS (Low Voltage Differential Signaling) eingesetzt werden, der ein Schnittstellen-Standard für eine Hochgeschwindigkeits-Datenübertragung ist, bei welcher ein Sender und ein Empfänger über eine Datenübertragungsstrecke miteinander verbunden sind. LVDS ist standardisiert nach ANSI/TIA/EIA-644-1995.

Die Anzahl und Anordnung der Teilnehmerstationen 10, 20, 30, 100 in dem Bussystem 1 gemäß den Ausführungsbeispielen und/oder deren Modifikationen ist beliebig. Insbesondere können auch nur Teilnehmerstationen 10 oder Teilnehmerstationen 30 oder Teilnehmerstationen 100 in den Bussystemen 1 der Ausführungsbeispiele und/oder deren Modifikationen vorhanden sein.

Die Funktionalität der zuvor beschriebenen Ausführungsbeispiele und/oder deren Modifikationen lässt sich jeweils in einem Transceiver bzw. einer Sende-/Empfangseinrichtung 12 bzw. Transceiver oder einem CAN-Transceiver oder einem Transceiver-Chipsatz oder einem CAN-Transceiver-Chipsatz, usw. umsetzen. Zusätzlich oder alternativ kann es in existierende Produkte integriert werden. Insbesondere ist es möglich, dass die betrachtete Funktionalität entweder im Transceiver als separater elektronischer Baustein (Chip) realisiert oder in einer integrierten Gesamtlösung, bei welchem nur ein elektronischer Baustein (Chip) vorhanden ist, eingebettet ist.

## Patentansprüche

1. Sende-/Empfangseinrichtung (12; 120; 1200) für ein Bussystem (1), mit
einem Empfangskomparator (1221) zum Empfang eines Signals, das von einem Bus (40) des Bussystems (1) übertragen wird, bei weichem Bussystem (1) zumindest zeitweise ein exklusiver, kollisionsfreier Zugriff einer Teilnehmerstation (10, 20, 30) auf den Bus (40) des Bussystems (1) gewährleistet ist, und
einer Schwingungsreduktionseinheit (15; 150), deren Eingang parallel zu dem Eingang des Empfangskomparators (1221) geschaltet ist,
wobei die Schwingungsreduktionseinheit (15; 150) ausgestaltet ist, bei Erfassen eines Zustandswechsels des empfangenen Signals von einem dominanten Buszustand (402) zu einem rezessiven Buszustand (401) mindestens eine Busader (41; 42) des Busses (40) mit einem Busvorspannungspotenzial zu verbinden,
wobei die Schwingungsreduktionseinheit (15; 150) aufweist:
einen Erfassungsblock (151; 151, 152), welcher ausgestaltet ist, einen Zustandswechsel des empfangenen Signals von dem dominanten Buszustand (402) zu dem rezessiven Buszustand (401) zu erfassen;
Transistoren (155, 156; 159, 160), weiche derart verschaltet sind, um bei Erfassen eines Zustandswechsels des empfangenen Signals von dem dominanten Buszustand (402) zu dem rezessiven Buszustand (401) die mindestens eine Busader (41; 42) des Busses (40) mit einer Busvorspannungseinheit (1223) zu verbinden;
einen Phasenlage-Erfassungsblock (152) zum Erfassen der zeitlichen Lage der Signale auf den Busadern (41, 42) des Busses (40) zueinander; und
mindestens einen RS-Zeitsteuerungsblock (153; 153, 154), der jeweils zum Steuern des Signals auf einer Busader (41; 42) in Abhängigkeit von dem Erfassungsergebnis des Phasenlage-Erfassungsblocks (152) ausgestaltet ist, um die Phasenlage des Signals auf der Busader (41; 42) einzustellen,
**dadurch gekennzeichnet, dass** die RS-Zeitsteuerungsblöcke (153; 153, 154) derart ausgestaltet sind, dass die Zeit der Ansteuerung der Transistoren (155, 156; 159, 160) in Bruchteilen der Bitzeit einstellbar ist.

2. Sende-/Empfangseinrichtung (12; 120; 1200) nach Anspruch 1, wobei das Busvorspannungspotenzial auf die Hälfte des Werts der Spannungsversorgung für den Bus (40) eingestellt ist.

3. Sende-/Empfangseinrichtung (12; 120) nach einem der vorangehenden Ansprüche,
wobei die Schwingungsreduktionseinheit (15; 150) einen Kommunikationsphasen-Erfassungsblock (165) zum Erfassen von unterschiedlichen Phasen einer Kommunikation auf dem Bus (40) aufweist, und
wobei mindestens ein RS-Zeitsteuerungsblock (153; 153, 154) ausgestaltet ist, das Signal auf einer Busader (41; 42) abhängig von der erfassten Phase der Kommunikation auf dem Bus (40) zu steuern.

4. Sende-/Empfangseinrichtung (12; 120) nach Anspruch 3, wobei der Kommunikationsphasen-Erfassungsblock (165) ausgestaltet ist, mindestens ein Endebit (454) zu erfassen, welches das Ende einer Nachricht (45; 47) anzeigt, um die unterschiedlichen Phasen einer Kommunikation auf dem Bus (40) zu erfassen.

5. Sende-/Empfangseinrichtung (12; 120) nach Anspruch 3 oder 4, wobei der mindestens eine RS-Zeitsteuerungsblock (153; 153, 154) ausgestaltet ist, das Signal auf einer Busader (41; 42) nach Abschluss einer Arbitrationsphase (451; 453) der Kommunikation zu steuern.

6. Sende-/Empfangseinrichtung (12; 120) nach einem der vorangehenden Ansprüche,
zudem mit einem Sender (121) zum Senden von Nachrichten (45; 47) auf den Bus (40),
wobei die Schwingungsreduktionseinheit (15; 150) derart ausgestaltet ist, dass die Schwingungsreduktionseinheit (15; 150) nur aktiviert ist, wenn der Sender (121) eine Nachricht (45; 47) auf den Bus (40) sendet.

7. Bussystem (1), mit
einem Bus (40), und
mindestens zwei Teilnehmerstationen (10; 20; 30; 100), welche über den Bus (40) derart miteinander verbunden sind, dass sie miteinander kommunizieren können,
wobei mindestens eine der mindestens zwei Teilnehmerstationen (10; 20; 30) eine Sende-/Empfangseinrichtung (12; 120; 1200) nach einem der vorangehenden Ansprüche aufweist.

8. Bussystem (1) nach Anspruch 7, wobei eine der mindestens zwei Teilnehmerstationen (100) eine Kommunikationssteuereinrichtung (110) aufweist, welche ausgestaltet ist, ein Signal (TxD) an die Sende-/Empfangseinrichtung (1200) zu senden, welches die Sende-/Empfangseinrichtung (1200) als Grundlage für die Signale (CAN_H, CAN_L) für die Busadern (41, 42) verwendet, und das Signal (TxD) mit einem von der Sende-/Empfangseinrichtung (1200) vom Bus (40) empfangenen Signal (RxD) zur Erzeugung eines Steuersignals zu vergleichen, und wobei die Kommunikationssteuereinrichtung (110) ausgestaltet ist, das Steuersignal zur Steuerung der Schwingungsreduktionseinheit (1500) an die Sende-/Empfangseinrichtung (1200) auszugeben.

9. Verfahren zur Reduzierung einer Schwingneigung beim Übergang zwischen unterschiedlichen Bitzuständen, wobei das Verfahren mit einer Sende-/Empfangseinrichtung (12; 120; 1200) für ein Bussystem (1) ausgeführt wird, bei welchem zumindest zeitweise ein exklusiver, kollisionsfreier Zugriff einer Teilnehmerstation (10, 20, 30, 100) auf einen Bus (40) des Bussystems (1) gewährleistet ist, wobei die Sende-/Empfangseinrichtung (12; 120; 1200) einen Empfangskomparator (1221) und eine Schwingungsreduktionseinheit (15; 150) aufweist, und wobei das Verfahren die Schritte aufweist, Empfangen, mit dem Empfangskomparator (1221), eines Signals, das von dem Bus (40) übertragen wird, wobei der Eingang des Empfangskomparators (1221) parallel zu einem Eingang der Schwingungsreduktionseinheit (15; 150) geschaltet ist,
Erfassen eines Zustandswechsels des empfangenen Signals von einem dominanten Buszustand (402) zu einem rezessiven Buszustand (401), Verbinden, bei Erfassen eines Zustandswechsels des empfangenen Signals von dem dominanten Buszustand (402) zu dem rezessiven Buszustand (401), mindestens einer Busader (41; 42) des Busses (40) mit einem Busvorspannungspotenzial mittels Transistoren (155, 156; 159, 160),
Erfassen der zeitlichen Phasenlage der Signale auf den Busadern (41, 42) des Busses (40) zueinander,
Einstellen der Phasenlage des Signals auf der Busader (41; 42) in Abhängigkeit von dem Erfassungsergebnis der Phasenlage durch mindestens eines RS-Zeitsteuerungsblocks (153; 153, 154) zum Steuern des Signals auf einer Busader (41; 42) mittels der Transistoren,
**dadurch gekennzeichnet, dass** der mindestens eine RS-Zeitsteuerungsblock zur Ansteuerung der Transistoren (155, 156; 159, 160) in Bruchteilen der Bitzeit einstellbar ist.

## Claims

1. Transmission/reception device (12; 120; 1200) for a bus system (1), having
a reception comparator (1221) for receiving a signal that is transmitted by a bus (40) of the bus system (1), which bus system (1) exhibits at least intermittently ensured exclusive collision-free access by a subscriber station (10, 20, 30) to the bus (40) of the bus system (1), and
an oscillation reduction unit (15; 150), the input of which is connected in parallel with the input of the reception comparator (1221),
wherein the oscillation reduction unit (15; 150) is configured to respond to detection of a change of state of the received signal from a dominant bus state (402) to a recessive bus state (401) by connecting at least one bus wire (41; 42) of the bus (40) to a bus bias voltage potential,
wherein the oscillation reduction unit (15; 150) comprises:
a detection block (151; 151, 152) that is configured to detect a change of state of the received signal from the dominant bus state (402) to the recessive bus state (401) ;
transistors (155, 156; 159, 160) that are connected up in such a way as to respond to detection of a change of state of the received signal from the dominant bus state (402) to the recessive bus state (401) by connecting the at least one bus wire (41; 42) of the bus (40) to a bus bias voltage unit (1223);
a phase angle detection block (152) for detecting the temporal position of the signals on the bus wires (41, 42) of the bus (40) in relation to one another; and
at least one RS timing block (153; 153, 154) that is respectively configured to control the signal on a bus wire (41; 42) on the basis of the detection result of the phase angle detection block (152) in order to adjust the phase angle of the signal on the bus wire (41; 42),
**characterized in that** the RS timing blocks (153; 153, 154) are configured in such a way that the time of actuation of the transistors (155, 156; 159, 160) is adjustable in fractions of the bit time.

2. Transmission/reception device (12; 120; 1200) according to Claim 1, wherein the bus bias voltage potential is set to half the value of the voltage supply for the bus (40).

3. Transmission/reception device (12; 120) according to either of the preceding claims,
wherein the oscillation reduction unit (15; 150) comprises a communication phase detection block (165) for detecting different phases of a communication on the bus (40), and
wherein at least one RS timing block (153; 153, 154) is configured to control the signal on a bus wire (41; 42) on the basis of the detected phase of the communication on the bus (40).

4. Transmission/reception device (12; 120) according to Claim 3, wherein the communication phase detection block (165) is configured to detect at least one end bit (454) that indicates the end of a message (45; 47) in order to detect the different phases of a communication on the bus (40).

5. Transmission/reception device (12; 120) according to Claim 3 or 4, wherein the at least one RS timing block (153; 153, 154) is configured to control the signal on a bus wire (41; 42) following the conclusion of an arbitration phase (451; 453) of the communication.

6. Transmission/reception device (12; 120) according to one of the preceding claims,
also having a transmitter (121) for transmitting messages (45; 47) to the bus (40),
wherein the oscillation reduction unit (15; 150) is configured in such a way that the oscillation reduction unit (15; 150) is activated only if the transmitter (121) transmits a message (45; 47) to the bus (40).

7. Bus system (1), having
a bus (40), and
at least two subscriber stations (10; 20; 30; 100) that are connected to one another via the bus (40) in such a way that they are able to communicate with one another, wherein at least one of the at least two subscriber stations (10; 20; 30) comprises a transmission/reception device (12; 120; 1200) according to one of the preceding claims.

8. Bus system (1) according to Claim 7, wherein one of the at least two subscriber stations (100) comprises a communication control device (110) that is configured to transmit a signal (TxD) to the transmission/reception device (1200) that the transmission/reception device (1200) uses as a basis for the signals (CAN_H, CAN_L) for the bus wires (41, 42), and to compare the signal (TxD) with a signal (RxD) received by the transmission/reception device (1200) from the bus (40) in order to generate a control signal, and wherein the communication control device (110) is configured to output the control signal to the transmission/reception device (1200) to control the oscillation reduction unit (1500).

9. Method for reducing an inclination toward oscillation when transitioning between different bit states, the method being carried out using a transmission/reception device (12; 120; 1200) for a bus system (1), which bus system (1) exhibits at least intermittently ensured exclusive collision-free access by a subscriber station (10, 20, 30, 100) to a bus (40) of the bus system (1), wherein the transmission/reception device (12; 120; 1200) comprises a reception comparator (1221) and an oscillation reduction unit (15; 150), and wherein the method has the steps of
receiving, using the reception comparator (1221), a signal that is transmitted by the bus (40), the input of the reception comparator (1221) being connected in parallel with an input of the oscillation reduction unit (15; 150),
detecting a change of state of the received signal from a dominant bus state (402) to a recessive bus state (401),
connecting, upon detection of a change of state of the received signal from the dominant bus state (402) to the recessive bus state (401), at least one bus wire (41; 42) of the bus (40) to a bus bias voltage potential by means of transistors (155, 156; 159, 160), detecting the temporal phase angle of the signals on the bus wires (41, 42) of the bus (40) in relation to one another,
adjusting the phase angle of the signal on the bus wire (41; 42) on the basis of the detection result for the phase angle by way of at least one RS timing block (153; 153, 154) for controlling the signal on a bus wire (41; 42) by means of the transistors, **characterized in that** the at least one RS timing block is adjustable in fractions of the bit time for the purpose of actuating the transistors (155, 156; 159 160) .

## Revendications

1. Dispositif émetteur/récepteur (12 ; 120 ; 1200) destiné à un système de bus (1), comprenant
un comparateur de réception (1221) servant à recevoir un signal qui est transmis par un bus (40) du système de bus (1), dans lequel système de bus (1) un accès exclusif sans collision d'une station périphérique (10, 20, 30) au bus (40) du système de bus (1) est garanti au moins temporairement, et
une unité de réduction d'oscillation (15 ; 150) dont l'entrée est connectée en parallèle à l'entrée du comparateur de réception (1221),
l'unité de réduction d'oscillation (15 ; 150) étant configurée pour relier au moins un fil de bus (41 ; 42) du bus (40) à un potentiel de polarisation de bus lors de la détection d'un changement d'état du signal reçu d'un état de bus dominant (402) à un état de bus récessif (401),
l'unité de réduction d'oscillation (15 ; 150) présentant :
un bloc de détection (151 ; 151, 152) qui est configuré pour détecter un changement d'état du signal reçu de l'état de bus dominant (402) à l'état de bus récessif (401) ;
des transistors (155, 156 ; 159, 160) qui sont connectés de façon à relier ledit au moins un fil de bus (41 ; 42) du bus (40) à une unité de polarisation de bus (1223) lors de la détection d'un changement d'état du signal reçu de l'état de bus dominant (402) à l'état de bus récessif (401) ;
un bloc de détection de position de phase (152) servant à détecter la position dans le temps des signaux sur les fils de bus (41, 42) du bus (40) les uns par rapport aux autres ; et
au moins un bloc de synchronisation RS (153 ; 153, 154) qui est configuré respectivement pour commander le signal sur un fil de bus (41 ; 42) en fonction du résultat de détection du bloc de détection de position de phase (152) afin de régler la position de phase du signal sur le fil de bus (41 ; 42),
**caractérisé en ce que** les blocs de synchronisation RS (153 ; 153, 154) sont configurés de telle sorte que le temps du pilotage des transistors (155, 156 ; 159, 160) peut être réglé en fractions du temps binaire.

2. Dispositif émetteur/récepteur (12 ; 120 ; 1200) selon la revendication 1, dans lequel le potentiel de polarisation de bus est réglé sur la moitié de la valeur de l'alimentation en tension pour le bus (40).

3. Dispositif émetteur/récepteur (12 ; 120) selon l'une quelconque des revendications précédentes,
dans lequel l'unité de réduction d'oscillation (15 ; 150) présente un bloc de détection de phase de communication (165) servant à détecter différentes phases d'une communication sur le bus (40), et
dans lequel au moins un bloc de synchronisation RS (153 ; 153, 154) est configuré pour commander le signal sur un fil de bus (41 ; 42) en fonction de la phase détectée de la communication sur le bus (40).

4. Dispositif émetteur/récepteur (12 ; 120) selon la revendication 3, dans lequel le bloc de détection de phase de communication (165) est configuré pour détecter au moins un bit de fin (454) qui indique la fin d'un message (45 ; 47) afin de détecter les différentes phases d'une communication sur le bus (40).

5. Dispositif émetteur/récepteur (12 ; 120) selon la revendication 3 ou 4, dans lequel ledit au moins un bloc de synchronisation RS (153 ; 153, 154) est configuré pour commander le signal sur un fil de bus (41 ; 42) à l'issue d'une phase d'arbitrage (451 ; 453) de la communication.

6. Dispositif émetteur/récepteur (12 ; 120) selon l'une quelconque des revendications précédentes,
comprenant en outre un émetteur (121) servant à émettre des messages (45 ; 47) sur le bus (40),
l'unité de réduction d'oscillation (15 ; 150) étant configurée de telle sorte que l'unité de réduction d'oscillation (15 ; 150) n'est activée que si l'émetteur (121) émet un message (45 ; 47) sur le bus (40).

7. Système de bus (1), comprenant
un bus (40), et
au moins deux stations périphériques (10 ; 20 ; 30 ;
100) qui sont reliées ensemble par l'intermédiaire du bus (40) de telle sorte qu'elles peuvent communiquer les unes avec les autres,
au moins l'une des au moins deux stations périphériques (10 ; 20 ; 30) présentant un dispositif émetteur/récepteur (12 ; 120 ; 1200) selon l'une quelconque des revendications précédentes.

8. Système de bus (1) selon la revendication 7, dans lequel l'une des au moins deux stations périphériques (100) présente un dispositif de commande de communication (110) qui est configuré pour émettre un signal (TxD) à destination du dispositif émetteur/récepteur (1200) que le dispositif émetteur/récepteur (1200) utilise comme base pour les signaux (CAN_H, CAN_L) destinés aux fils de bus (41, 42), et pour comparer le signal (TxD) avec un signal (RxD) reçu par le dispositif émetteur/récepteur (1200) du bus (40) afin de générer un signal de commande, et dans lequel le dispositif de commande de communication (110) est configuré pour sortir au dispositif émetteur/récepteur (1200) le signal de commande pour commander l'unité de réduction d'oscillation (1500).

9. Procédé permettant de réduire une tendance à l'oscillation lors du passage entre différents états binaires, le procédé étant exécuté par un dispositif émetteur/récepteur (12 ; 120 ; 1200) destiné à un système de bus (1) dans lequel un accès exclusif sans collision d'une station périphérique (10, 20, 30, 100) à un bus (40) du système de bus (1) est garanti au moins temporairement, le dispositif émetteur/récepteur (12 ; 120 ; 1200) présentant un comparateur de réception (1221) et une unité de réduction d'oscillation (15 ; 150), et le procédé présentant les étapes consistant à
recevoir, par le comparateur de réception (1221), un signal qui est transmis par le bus (40), l'entrée du comparateur de réception (1221) étant connectée en parallèle à une entrée de l'unité de réduction d'oscillation (15 ; 150),
détecter un changement d'état du signal reçu d'un état de bus dominant (402) à un état de bus récessif (401),
relier, lors de la détection d'un changement d'état du signal reçu de l'état de bus dominant (402) à l'état de bus récessif (401), au moins un fil de bus (41 ; 42) du bus (40) à un potentiel de polarisation de bus au moyen de transistors (155, 156 ; 159, 160),
détecter la position de phase dans le temps des signaux sur les fils de bus (41, 42) du bus (40) les uns par rapport aux autres,
régler la position de phase du signal sur le fil de bus (41 ; 42) en fonction du résultat de détection de la position de phase par au moins un bloc de synchronisation RS (153 ; 153, 154) pour commander le signal sur un fil de bus (41 ; 42) au moyen des transistors,
**caractérisé en ce que** ledit au moins un bloc de synchronisation RS peut être réglé en fractions du temps binaire pour piloter les transistors (155, 156 ; 159, 160) .
